(19) Europäisches Patentamt
European Patent Office
Office européen des brevets

(11) Veröffentlichungsnummer: **0 157 929**
**B1**

(12) # EUROPÄISCHE PATENTSCHRIFT

(45) Veröffentlichungstag der Patentschrift: **27.04.88**

(51) Int. Cl.⁴: **C 08 G 73/06**, C 08 G 73/12, G 03 F 7/26, G 03 C 1/70, H 01 L 21/47

(21) Anmeldenummer: **84115192.1**

(22) Anmeldetag: **12.12.84**

(54) **Verfahren zur Herstellung von Polyimid- und Polyisoindolochinazolindion-Vorstufen.**

(30) Priorität: **29.03.84 DE 3411660**

(43) Veröffentlichungstag der Anmeldung:
**16.10.85 Patentblatt 85/42**

(45) Bekanntmachung des Hinweises auf die Patenterteilung:
**27.04.88 Patentblatt 88/17**

(84) Benannte Vertragsstaaten:
**AT BE CH DE FR GB IT LI NL SE**

(56) Entgegenhaltungen:
**DE-A-2 308 830**
**DE-A-2 933 826**
**DE-B-1 202 981**

**Die Akte enthält technische Angaben, die nach dem Eingang der Anmeldung eingereicht wurden und die nicht in dieser Patentschrift enthalten sind.**

(73) Patentinhaber: **Siemens Aktiengesellschaft Berlin und München, Wittelsbacherplatz 2, D-8000 München 2 (DE)**

(72) Erfinder: **Ahne, Hellmut, Dr., Heidestrasse 6, D-8551 Röttenbach (DE)**
Erfinder: **Kühn, Eberhard, Bergstrasse 32, D-8551 Hemhofen (DE)**

**EP 0 157 929 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1988

**Beschreibung**

Die Erfindung betrifft ein Verfahren zur Herstellung oligomerer und/oder polymerer strahlungsreaktiver Vorstufen von Polyimiden und Polyisoindolochinazolindionen sowie die Verwendung dieser strahlungsreaktiven Vorstufen.

Lösliche strahlungsreaktive Polyimid- und Polyisoindolochinazolindion-Vorstufen werden beispielsweise zur einfachen photolithographischen Erzeugung hochwärmebeständiger strukturierter Schutz- und Isolierschichten in der Halbleitertechnik benötigt. Aus Kostengründen werden dabei Herstellungsverfahren für die Vorstufen angestrebt, bei denen keine aufwendigen Reinigungsprozesse erforderlich sind, insbesondere zur Entfernung von Chlorid.

Polyimid- und Polyisoindolochinazolindion-Vorstufen der genannten Art, die in organischen Lösungsmitteln löslich sind, sind beispielsweise aus der DE-C-2 308 830 bekannt. Diese Vorstufen sind Polykondensationsprodukte polyfunktioneller carbocyclischer oder heterocyclischer, strahlungsempfindliche Reste tragender Verbindungen mit Diaminen. Die strahlungsempfindliche Reste tragenden Verbindungen enthalten zwei für Kondensationsreaktionen geeignete Carbonsäurechloridgruppen und teilweise in ortho- oder peri-Stellung dazu esterartig an Carboxylgruppen gebundene strahlungsreaktive Gruppen. Die mit diesen Verbindungen umzusetzenden Diamine weisen mindestens ein cyclisches Strukturelement auf.

Strahlungsreaktive Polyimid-Vorstufen werden dabei insbesondere in der Weise hergestellt, daß ungesättigte Alkohole, wie Allylalkohol, an Tetracarbonsäuredianhydride, wie Pyromellithsäuredianhydrid, addiert, die freien Carbonsäuregruppen der dabei gebildeten Diester in Säurechloridgruppen übergeführt und die entstandenen Diester-bis-säurechloride einer Polykondensationsreaktion mit einem - meist aromatischen - Diamin unterworfen werden. Bei der Verwendung von Diaminoverbindungen, die ortho-ständige Amidogruppen aufweisen, entstehen in entsprechender Weise Polyisoindolochinazolindione.

Das bekannte Herstellungsverfahren erfordert somit mehrere Reaktionsschritte, darüber hinaus muß bei tiefen Temperaturen gearbeitet werden. Ferner ist bei der Verwendung von Säurechloriden eine intensive Reinigung der Reaktionsprodukte erforderlich.

Zur Herstellung von oligomeren und/oder polymeren strahlungsreaktiven Vorstufen von Polyimiden und Polyisoindolochinazolindionen ist ferner ein Verfahren bekannt, bei welchem olefinisch ungesättigte Monoepoxide mit carboxylgruppenhaltigen Polyadditionsprodukten aus aromatischen und/oder heterocyclischen Tetracarbonsäuredianhydriden und Diaminoverbindungen bzw. Diaminoverbindungen mit wenigstens einer ortho-ständigen Amidogruppe zur Reaktion gebracht werden (DE-A 2 933 826). Diese Reaktionen laufen aber häufig nicht vollständig ab, so daß die auf diese Weise erhaltenen Vorstufen hinsichtlich des strahlungsreaktiven Charakters beeinträchtigt sein können.

Aufgabe der Erfindung ist es, ein Verfahren anzugeben, das in einfacher Weise die Herstellung von in organischen Lösungsmitteln löslichen Polyimid- und Polyisoindolochinazolindion-Vorstufen erlaubt, die zugleich strahlungsreaktiv und von hoher Reinheit, d. h. insbesondere chloridfrei sind.

Dies wird erfindungsgemäß dadurch erreicht, daß ein aromatisches und/oder heterocyclisches Tetracarbonsäuredianhydrid mit einem olefinisch ungesättigten Alkohol zu einem olefinisch ungesättigten Tetracarbonsäurediester umgesetzt wird und daß der Tetracarbonsäurediester in Gegenwart eines Carbodiimids mit einer Diaminoverbindung oder einer Diaminoverbindung mit wenigstens einer ortho-ständigen Amidogruppe zur Reaktion gebracht wird.

Unter "Tetracarbonsäuredianhydrid" werden im Rahmen der vorliegenden Patentanmeldung Verbindungen verstanden, die wenigstens zwei Säureanhydridgruppierungen aufweisen. Der Begriff "Diaminoverbindung" soll auch Verbindungen umfassen, die das Strukturelement FIG 01/01 enthalten, d. h. Abkömmlinge des Hydrazins. Unter "Diaminoverbindung mit wenigstens einer ortho-ständigen Amidogruppe" werden Verbindungen verstanden, die wenigstens eine zu einer der beiden Aminogruppen der Diaminoverbindung ortho-ständige Amidogruppe tragen.

Nach dem erfindungsgemäßen Verfahren können Polyimid- und Polyisoindolochinazolindion-Vorstufen auf einfachem Weg synthetisiert werden. Diese Vorstufen sind sehr strahlungsreaktiv und können somit leicht vernetzt werden. Die vernetzten Produkte können dann durch eine thermische Behandlung in einfacher Weise in hochwärmebeständige Polyimide bzw. Polyisoindolochinazolindione übergeführt werden.

Das erfindungsgemäße Verfahren wird im allgemeinen in einem Lösungsmittel durchgeführt. Dabei scheidet sich dann - bei der Polykondensation zwischen dem Tetracarbonsäurediester und dem Diamin - der dem eingesetzten Carbodiimid zugrundeliegende Harnstoff ab, und zwar bereits bei Raumtemperatur. Dabei werden hochreine, insbesondere chloridfreie Lösungen der strahlungsreaktiven Vorstufen erhalten. Diese Vorstufen sind nämlich in organischen Lösungsmitteln, insbesondere in polaren Lösungsmitteln mit hohem Flammpunkt, gut löslich. Die Lösungen der Vorstufen können nach der Abtrennung des als Nebenprodukt in sehr reiner Form anfallenden Harnstoffderivates direkt weiter verwendet werden, was in wirtschaftlicher Hinsicht von Bedeutung ist. Es kann aber auch in der Weise vorgegangen werden, daß die Vorstufen durch Ausfällen als Festharz isoliert werden. Auf jeden Fall können aber aus Lösungen der Vorstufen homogene Schichten in einem weiten Schichtdickenbereich hergestellt und beispielsweise durch UV-Bestrahlung gehärtet werden.

Beim erfindungsgemäßen Verfahren wird die Umsetzung des Tetracarbonsäurediesters mit der Diaminoverbindung bzw. der Diaminoverbindung mit wenigstens einer Amidogruppe vorteilhaft bei Raumtemperatur, gegebenenfalls in Gegenwart eines aminischen Katalysators, durchgeführt; dabei können

auch verschiedene Diaminoverbindungen nebeneinander zum Einsatz gelangen. Vorzugsweise werden die Tetracarbonsäurediester und die Diaminoverbindung bei Raumtemperatur zu einer möglichst homogenen Lösung vereinigt zu der dann unter Rühren ein Carbodiimid in Form einer Lösung zugetropft wird. Es kann aber auch stufenweise vorgegangen werden, indem zunächst ein Additionsprodukt aus dem Carbodiimid und der Diester-bis-carbonsäure hergestellt wird, das dann in einer weiteren Reaktion mit dem Diamin unter Abscheidung des Harnstoffderivates umgesetzt wird.

Das erfindungsgemäße Verfahren ist präparativ einfach durchzuführen, wobei im allgemeinen Raumtemperatur ausreichend ist. Da an der Reaktion keine Säurechloride beteiligt sind, entfallen aufwendige Reinigungsoperationen. Darüber hinaus fallen die Reaktionsprodukte, einschließlich der als Nebenprodukte entstehenden Harnstoffderivate, in sehr reinem Zustand an. Im übrigen ist beim erfindungsgemäßen Verfahren die überraschende Tatsache, daß die ungesättigten Diester-bis-carbonsäuren mit den Diaminen in Gegenwart von Carbodiimid so einheitlich und vollständig reagieren, und insbesondere auch die Tatsache, daß die Harnstoffderivate von den dabei erhaltenen Vorstufen gut abgetrennt werden können, von entscheidender Bedeutung.

Die nach dem erfindungsgemäßen Verfahren hergestellten Polymer-Vorstufen eignen sich insbesondere zur Herstellung von strukturierten, hochwärmebeständigen Schutz- und Isolierschichten in der Mikroelektronik (Feinstrukturerzeugung) sowie zur Verwendung als Photoresist (siehe dazu die gleichzeitig eingereichte europäische Patentanmeldung "Verfahren zur Herstellung von Polyimid- und Polyisoindolochinazolindion-Reliefstrukturen", Anmeldenummer 84115193.9 - EP-A-0 157 930).

Die erfindungsgemäß hergestellten strahlungsreaktiven Vorstufen weisen im allgemeinen folgende Struktur auf:

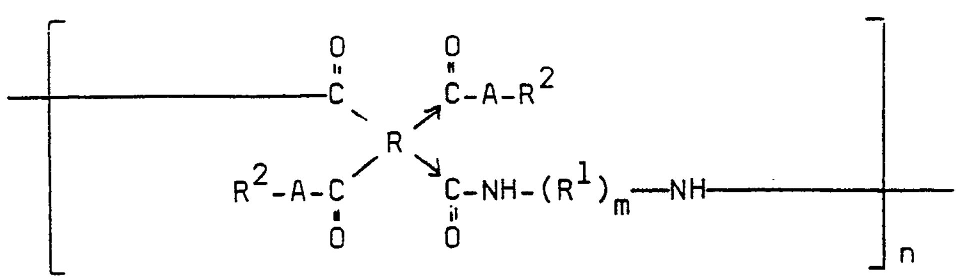

Mit den in der Formel enthaltenen Pfeilen soll dabei die Tatsache zum Ausdruck gebracht werden, daß die beiden fraglichen Substituenten an R ihre Stellung vertauschen können. Dies ist deshalb von Bedeutung, weil es sich bei R, wie nachfolgend noch erläutert wird, um einen cyclischen Rest handelt.

In der Formel bedeutet n eine ganze Zahl von 2 bis etwa 100 und m ist 0 oder 1.

Für R, $R^1$, $R^2$ und A gilt folgendes:

R ist ein - gegebenenfalls halogenierter - zumindest partiell aromatischer und/oder heterocyclischer tetravalenter, d.h. tetrafunktioneller Rest, bei dem jeweils zwei Valenzen in Nachbarstellung zueinander angeordnet sind; weist der Rest R mehrere aromatische und/oder heterocyclische Strukturelemente auf, so befinden sich die Valenzpaare jeweils an endständigen derartigen Strukturelementen;

$R^1$ ist ein - gegebenenfalls halogenierter - divalenter, d.h. difunktioneller Rest aliphatischer und/oder cycloaliphatischer, gegebenenfalls Heteroatome aufweisender, und/oder aromatischer und/oder heterocyclischer Struktur;

$R^2$ ist ein olefinisch ungesättigter Rest, beispielsweise eine allyletherhaltige Gruppe, insbesondere eine - gegebenenfalls substituierte - (meth)acrylesterhaltige Gruppe oder eine Propargylgruppe;

A bedeutet -O- oder -NH-.

Die Reste R, $R^1$ und $R^2$ haben insbesondere folgende Bedeutung:

R = 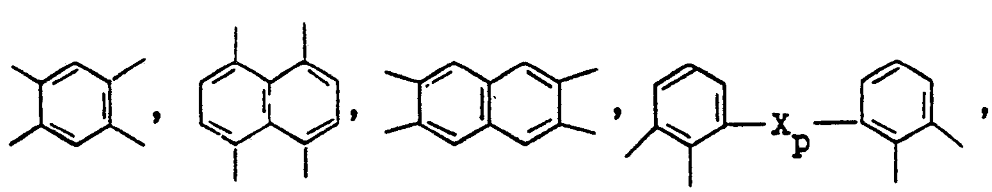

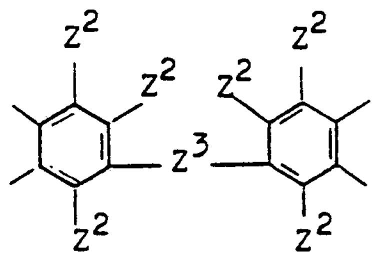

,

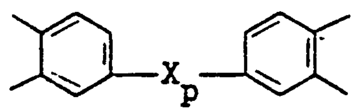

,

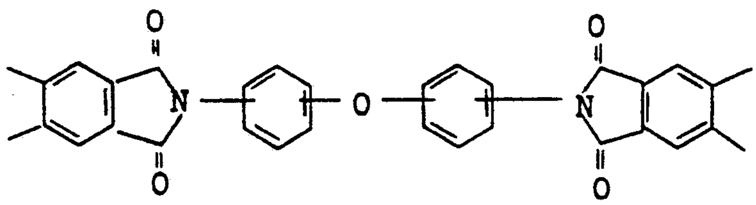

,

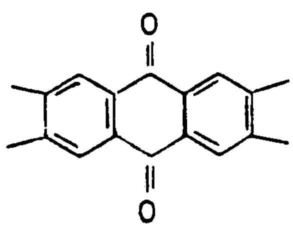

,

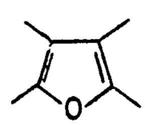

und

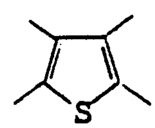

,

wobei p = 0 oder 1 ist und X für einen der nachfolgenden Reste steht.

X = -O-, 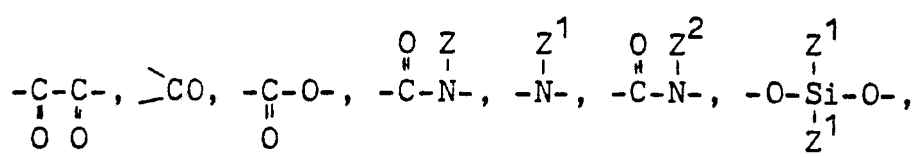

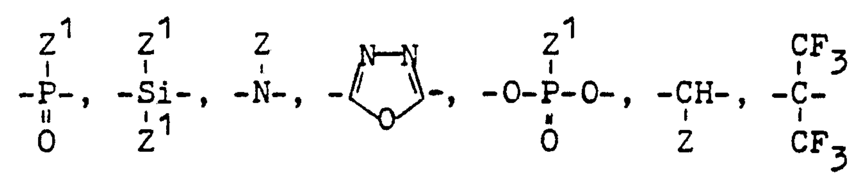

,

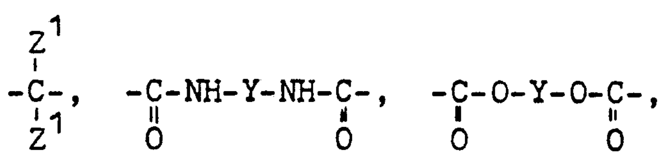

-SO-, $-SO_2-$,

$-SO_2NH-$, $-S-$, 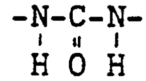, $-N=N-$,

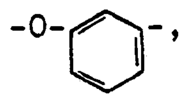, 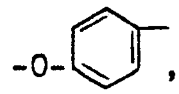, 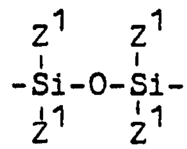 und 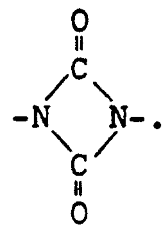.

Für die weiteren Reste gilt:

Y = 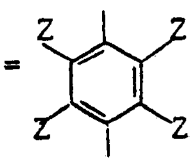, $-(CH_2)_o-$ mit o=2 bis 10, und

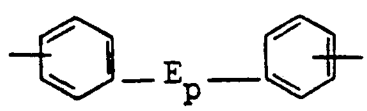 mit p=0 oder 1,

Z = H oder Alkyl mit 1 bis 6 Kohlenstoffatomen,
$Z^1$ = Alkyl mit 1 bis 10 Kohlenstoffatomen oder Aryl,
$Z^2$ = Aryl oder Heteroaryl, und
$Z^3$ = 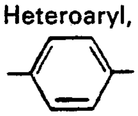 oder 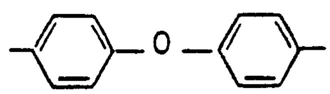 ;

E = 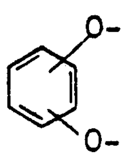, 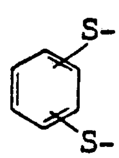, 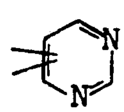, 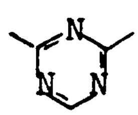, 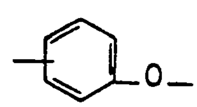,

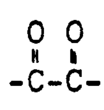, 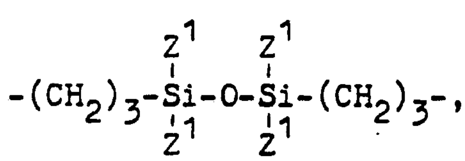, 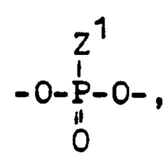, 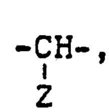,

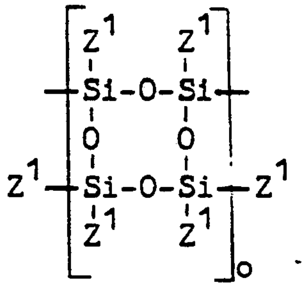 , 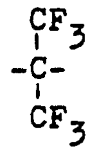 ,

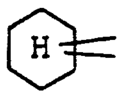 , $-(CH_2)_q-$, $-(CF_2)_r-$, $-SO-$, $-SO_2-$,

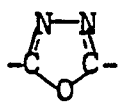, $-SO_2NH-$, 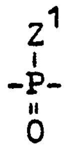, 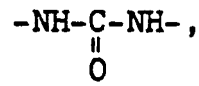, 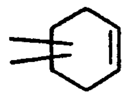 ,

$-N{=}N-$, 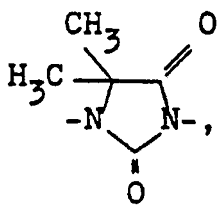, $-S-$, $-O-$, 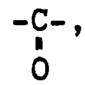, 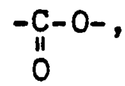,

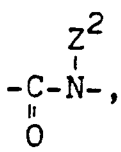, 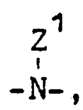, 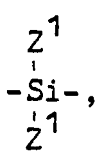, 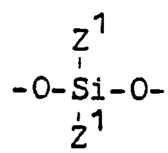 und 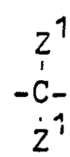 ,

wobei o=2 bis 10, q=2 bis 14 und r=2 bis 18, und $Z^1$ und $Z^2$ wie vorstehend definiert sind.

$R^1$ = 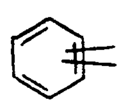, 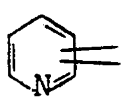, 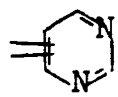, 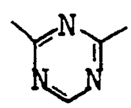, 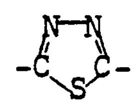 ,

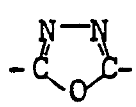 , 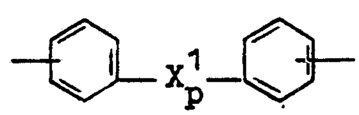 ,

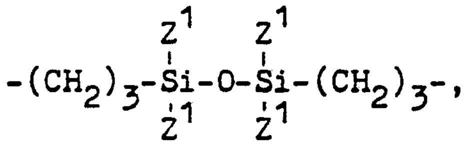, 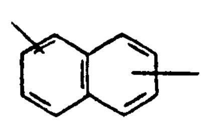 , 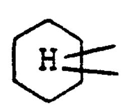 ,

$-(CH_2)_q-$, $-(CF_2)_r-$, 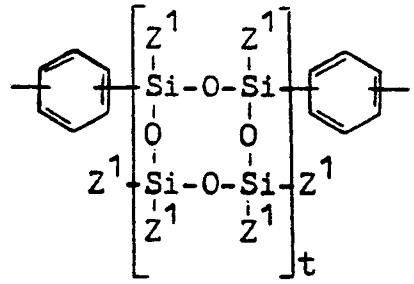 ,

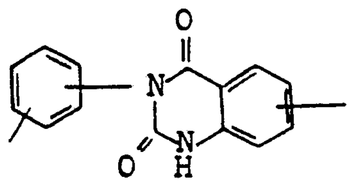 , 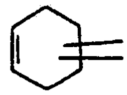 , 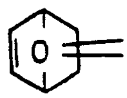 , 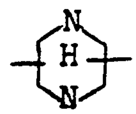 ,

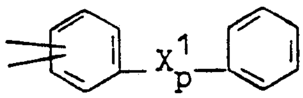 , 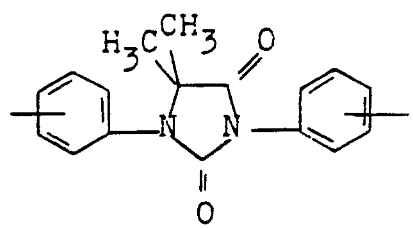 ,

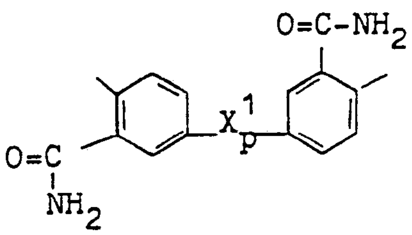 und 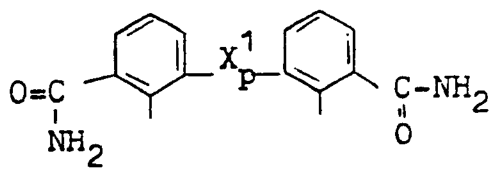 ,

wobei p = 0 oder 1, q = 2 bis 14, r = 2 bis 18 und t = 1 bis 10, und Z wie vorstehend definiert ist;

$X^1$ = 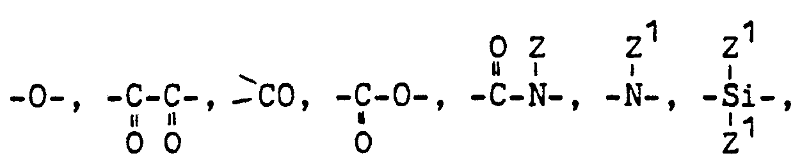

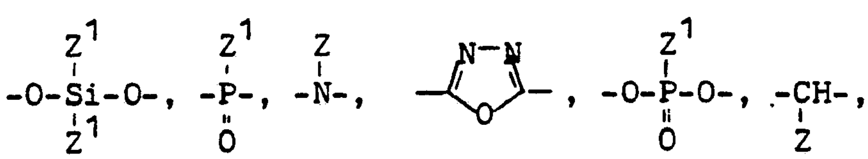

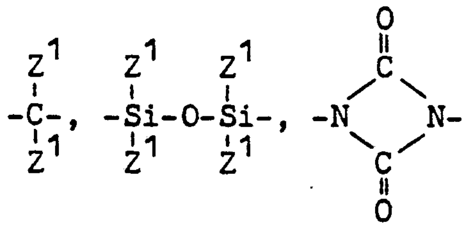, $-SO-$, $-SO_2-$, $-SO_2NH-$,

$-S-$, 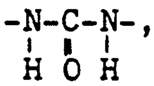, $-N{=}N-$, 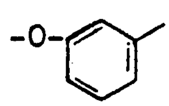, 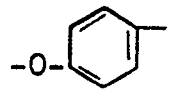,

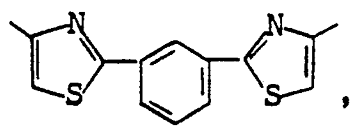, 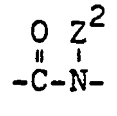 und 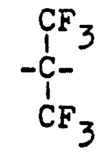,

wobei Z, $Z^1$ und $Z^2$ wie vorstehend definiert sind.

$R^2$ = 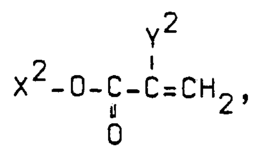, 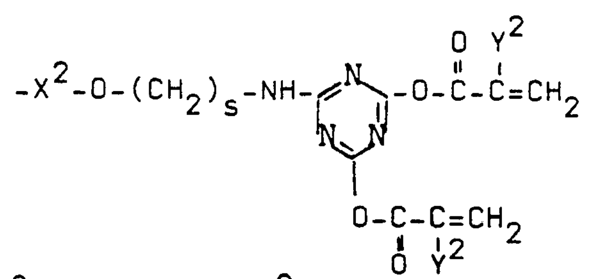,

$-X^2-C{\equiv}CH$, 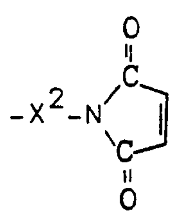, 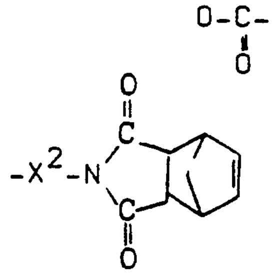,

$-X^2-O-CH_2-CH{=}CH_2$ und $-X^2-O-CH_2-C{\equiv}CH$;

dabei ist s = 2 bis 16;
für die weiteren Reste gilt:
$X^2 = -(-CH_2-)_r$ und $-CH_2-O-(CH_2)_r-O_t-(CH_2)_s-$, und
$Y^2 = -H, -CH_3, -Cl, -Br$ oder $-C{\equiv}N$,
wobei r = 2 bis 18, s = 2 bis 16 und t = 1 bis 10.

Die erfindungsgemäß hergestellten strahlungsreaktiven Vorstufen sind Polykondensationsprodukte von olefinisch ungesättigten difunktionellen Diestern und Diaminen (Polyimid-Vorstufen) bzw. o-Aminoamiden, d. h. Diaminen mit ortho-ständigen Amidogruppen (Polyisoindolochinazolindion-Vorstufen). Die zur Herstellung der Diester bevorzugt eingesetzten Tetracarbonsäuredianhydride sind das Anhydrid der Pyromellithsäure und der Benzophenontetracarbonsäure, unter den zu demselben Zweck eingesetzten ungesättigten Alkoholen werden Hydroxyethylacrylat und Hydroxyethylmethacrylat bevorzugt. Im übrigen können beim erfindungsgemäßen Verfahren sowohl verschiedene Tetracarbonsäuredianhydride als auch verschiedene Diaminoverbindungen nebeneinander verwendet werden. Bei den Diaminoverbindungen ist der 4.4'-Diaminodiphenylether bevorzugt, bei den o-Aminoamiden das 4.4'-Diaminodiphenyl-3.3'-dicarbonsäureamid. Besonders vorteilhaft können diese Amine auch in Kombination untereinander eingesetzt werden. Das

bevorzugt verwendete Carbodiimid ist Dicyclohexylcarbodiimid; Carbodiimide sind im übrigen Verbindungen vom Typ R'-N=C=N-R''.

Die erfindungsgemäß hergestellten Vorstufen weisen als Grundbausteine bevorzugt aromatische Carbonsäuren auf und ergeben somit bei der thermischen Behandlung Polymere mit folgenden Struktureinheiten:

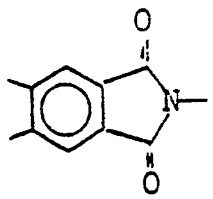
;
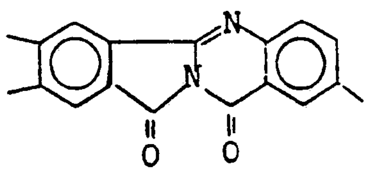
;

Polyimid

Polyisoindolochinazolindion

Der Begriff "Polyimide" soll dabei auch Polyesterimide und Polyamidimide umfassen:

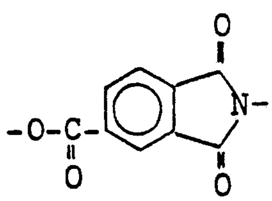
;
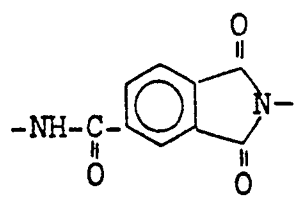

Polyesterimid

Polyamidimid

Außer zur Verwendung als Photoresist und zur Herstellung von Schutz- und Isolierschichten, wobei eine Strukturierung erfolgt, können die erfindungsgemäßen Vorstufen auch allgemein - in nicht strukturierter Form - zur Herstellung von Schutz- und Isolierüberzügen dienen.

Anhand von Ausführungsbeispielen soll die Erfindung noch näher erläutert werden.

**Beispiel 1**

Herstellung einer strahlungsreaktiven Polyimid-Vorstufe

Zu 32,2 Gewichtsteilen Benzophenontetracarbonsäuredianhydrid (0,1 Mol) in 50 Volumenteilen γ-Butyrolacton werden unter Rühren und Feuchtigkeitsausschluß 26 Gewichtsteile Hydroxyethylmethacrylat (0,2 Mol) und 0,2 Gewichtsteile 1.4-Diazabicyclo(2.2.2)octan gegeben. Nach 16stündigem Stehenlassen beträgt der titrimetrisch ermittelte Carboxylgehalt 0,22 Mol/100 g. Unter Rühren wird dann zur Reaktionslösung eine Lösung von 16 Gewichtsteilen 4.4'-Diaminodiphenylether (0,08 Mol) in 50 Volumenteilen N-Methylpyrrolidon gegeben. Danach wird in die Reaktionslösung eine Lösung von 36 Gewichtsteilen Dicyclohexylcarbodiimid (0,18 Mol) in 100 Volumenteilen γ-Butyrolacton getropft. Der sich dabei bildende Dicyclohexylharnstoff fällt als Niederschlag aus. Die Reaktionslösung wird dann bei Raumtemperatur über Nacht stehengelassen. Nach dem Abfiltrieren des Dicyclohexylharnstoffs wird eine viskose Harzlösung erhalten, die direkt zu Filmen und Folien weiterverarbeitet werden kann.

Durch Eintropfen der Harzlösung in destilliertes Wasser unter Rühren kann die photoreaktive Polyimid-Vorstufe aber auch als Festharz abgeschieden werden. Durch Filtration wird dann ein hellgelbes Pulver erhalten, das im Vakuum bei einem Druck von $1,3 \times 10^4$ Pa und einer Temperatur $\leqslant$ 40°C getrocknet wird. Die Viskositätszahl liegt bei 15,3 ml/g. Das IR-Spektrum zeigt die für Methacrylate typische Absorption bei 950 und 1630 $cm^{-1}$. Ein durch Schleudern hergestellter 5 µm dicker Film härtet bei Belichtung mit einer Quecksilberhöchstdrucklampe (350 W) innerhalb von 5 min.

**Beispiel 2**

Herstellung einer strahlungsreaktiven Polyisoindolochinazolindion-Vorstufe

Zu 43,6 Gewichtsteilen Pyromellithsäuredianhydrid (0,2 Mol) in 100 Volumenteilen N-Methylpyrrolidon

werden unter Rühren und Feuchtigkeitsausschluß 46,4 Gewichtsteile Hydroxyethylacrylat (0,4 Mol) und 0,4 Gewichtsteile 1.4-Diazabicyclo(2.2.2)octan gegeben. Die Reaktionslösung wird dann 15 h bei Raumtemperatur stehengelassen. Zu der Lösung des Diesters werden danach 51,7 Gewichtsteile 4.4'-Diaminodiphenyl-3.3'-dicarbonsäureamid (0,19 Mol) in 100 Volumenteilen eines Dimethylacetamid/N-Methylpyrrolidon-Gemisches (Volumenverhältnis 1 : 1) gegeben. Anschließend wird zu der Lösung unter Rühren und unter Kühlen eine Lösung von 74 Gewichtsteilen Dicyclohexylcarbodiimid (0,36 Mol) in 50 Volumenteilen N-Methylpyrrolidon getropft. Unter leichter Wärmetönung scheidet sich dabei Dicyclohexylharnstoff ab. Nach einer Nachreaktionszeit von 5 h wird der Dicyclohexylharnstoff durch Filtration abgetrennt. Die viskose Lösung kann durch Ausgießen auf ein Aluminiumblech und anschließendes Trocknen im Vakuumtrockenschrank bei einem Druck von 1,3 x $10^4$ Pa und einer Temperatur $\leqslant$ 40°C zu einem Film verarbeitet werden. Durch Belichten eines 7 µm dicken Filmes mit einer 500 W-Quecksilberhöchstdrucklampe wird der Film innerhalb von 4 min gehärtet.

Die strahlungsreaktive Polyisoindolochinazolindion-Vorstufe kann entsprechend Beispiel 1 auch als Festharz isoliert werden. Die für Acrylate typischen Absorptionsbanden bei 950 und 1630 $cm^{-1}$ sind im IR-Spektrum vorhanden.

**Patentansprüche**

1. Verfahren zur Herstellung oligomerer und/oder polymerer strahlungsreaktiver Vorstufen von Polyimiden und Polyisoindolochinazolindionen, dadurch gekennzeichnet, daß ein aromatisches und/oder heterocyclisches Tetracarbonsäuredianhydrid mit einem olefinisch ungesättigten Alkohol zu einem olefinisch ungesättigten Tetracarbonsäurediester umgesetzt wird und daß der Tetracarbonsäurediester in Gegenwart eines Carbodiimids mit einer Diaminoverbindung oder einer Diaminoverbindung mit wenigstens einer ortho-ständigen Amidogruppe zur Reaktion gebracht wird.

2. Verfahren nach Anspruch 1, dadurch gekennzeichnet, daß die Umsetzung des Tetracarbonsäurediesters mit der Diaminoverbindung bzw. der Diaminoverbindung mit wenigstens einer Amidogruppe bei Raumtemperatur, gegebenenfalls in Gegenwart eines aminischen Katalysators, durchgeführt wird.

3. Verfahren nach Anspruch 1 oder 2, dadurch gekennzeichnet, daß als Carbodiimid Dicyclohexylcarbodiimid eingesetzt wird.

4. Verfahren nach einem der Ansprüche 1 bis 3, dadurch gekennzeichnet, daß als Tetracarbonsäuredianhydrid Pyromellithsäureanhydrid oder Benzophenontetracarbonsäureanhydrid eingesetzt wird.

5. Verfahren nach einem oder mehreren der Ansprüche 1 bis 4, dadurch gekennzeichnet, daß als Diaminoverbindung 4.4'-Diaminodiphenylether eingesetzt wird.

6. Verfahren nach einem oder mehreren der Ansprüche 1 bis 4, dadurch gekennzeichnet, daß als Diaminoverbindung mit wenigstens einer Amidogruppe 4.4'-Diaminodiphenyl-3.3'-dicarbonsäureamid eingesetzt wird.

7. Verfahren nach einem oder mehreren der Ansprüche 1 bis 6, dadurch gekennzeichnet, daß als olefinisch ungesättigter Alkohol Hydroxyethylacrylat oder Hydroxyethylmethacrylat eingesetzt wird.

**Claims**

1. A process for producing oligomeric and/or polymeric radiation-reactive precursors of polyimides and polyisoindoloquinazoline diones, characterised in that an aromatic and/or heterocyclic tetracarboxylic acid dianhydride is reacted with an olefinic unsaturated alcohol to form an olefinic unsaturated tetracarboxylicacid diester and that the tetracarboxylicacid diester is caused to react in the presence of a carbodiimide with a diamino compound or with a diamino compound having at least one amido group in the ortho position.

2. A process according to claim 1, characterised in that the reaction of the tetracarboxylicacid diester with the diamino compound or the diamino compound having at least one amido group is carried out at room temperature, if need be in the presence of an aminic catalyst.

3. A process according to claim 1 or claim 2, characterised in that dicyclohexylcarbodiimide is used as the carbodiimide.

4. A process according to any one of claims 1 to 3, characterised in that pyromellitic acid anhydride or benzophenone tetracarboxylic acid anhydride is used as the tetracarboxylic acid dianhydride.

5. A process according to one or more of claims 1 to 4, characterised in that 4,4'-diaminodiphenyl ether is used as the diamino compound.

6. A process according to one or more of claims 1 to 4, characterised in that 4,4'-diaminodiphenyl-3,3'-dicarboxylic acid amide is used as the diamino compound having at least one amido group.

7. A process according to one or more of claims 1 to 6, characterised in that hydroxyethyl acrylate or hydroxyethyl methacrylate is used as the olefinic unsaturated alcohol.

**Revendications**

1. Procédé de préparation de précurseurs oligomères et/ou polymères, réactifs au rayonnement, de polyimides et de polyisoindoloquinazolinediones, caractérisé en ce qu'il consiste à faire réagir un dianhydride d'acide tétracarboxylique aromatique et/ou hétérocyclique sur un alcool à insaturation oléfinique, pour obtenir un diester d'acide tétracarboxylique à insaturation oléfinique et à mettre à réagir le diester d'acide tétracarboxylique en la présence d'un carbodiimide, sur un composé diaminé ou sur un composé diaminé ayant au moins un groupe amido en position ortho.

2. Procédé suivant la revendication 1, caractérisé en ce qu'il consiste à effectuer la réaction du diester d'acide tétracarboxylique sur le composé diaminé ou sur le composé diaminé ayant au moins un groupe amido, à la température ambiante, le cas échéant en présence d'un catalyseur aminé.

3. Procédé suivant la revendication 1 ou 2, caractérisé en ce qu'il consiste à utiliser du dicyclohexylcarbodiimide comme carbodiimide.

4. Procédé suivant l'une des revendications 1 à 3, caractérisé en ce qu'il consiste à utiliser de l'anhydride de l'acide pyromellitique ou de l'anhydride de l'acide benzophénonetétracarboxylique comme dianhydride d'acide tétracarboxylique.

5. Procédé suivant l'une ou plusieurs des revendications 1 à 4, caractérisé en ce qu'il consiste à utiliser de l'éther 4,4'-diaminodiphénylique comme composé diaminé.

6. Procédé suivant l'une ou plusieurs des revendications 1 à 4, caractérisé en ce qu'il consiste à utiliser l'amide de l'acide 4,4'-diaminodiphényl-3,3'-dicarboxylique comme composé diaminé ayant au moins un groupe amido.

7. Procédé suivant l'une ou plusieurs des revendications 1 à 6, caractérisé en ce qu'il consiste à utiliser de l'acrylate d'hydroxyéthyle ou du méthacrylate d'hydroxyéthyle comme alcool à insaturation oléfinique.